(19) Europäisches Patentamt
European Patent Office
Office européen des brevets

(11) **EP 4 629 649 A1**

(12) **EUROPEAN PATENT APPLICATION**
published in accordance with Art. 153(4) EPC

(43) Date of publication:
**08.10.2025 Bulletin 2025/41**

(21) Application number: **23897399.4**

(22) Date of filing: **07.11.2023**

(51) International Patent Classification (IPC):
**H04N 23/60** (2023.01)  **H04N 23/56** (2023.01)
**H04N 25/20** (2023.01)  **H04N 25/47** (2023.01)

(52) Cooperative Patent Classification (CPC):
**H04N 23/56; H04N 23/60; H04N 25/20; H04N 25/47**

(86) International application number:
**PCT/JP2023/040048**

(87) International publication number:
**WO 2024/116745 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.12.2022 JP 2022192953**

(71) Applicant: **Sony Group Corporation**
**Tokyo 108-0075 (JP)**

(72) Inventors:
• **SATO, Hidehito**
**Tokyo 108-0075 (JP)**
• **TAKATSUKA, Susumu**
**Tokyo 108-0075 (JP)**

(74) Representative: **MFG Patentanwälte**
**Meyer-Wildhagen Meggle-Freund**
**Gerhard PartG mbB**
**Amalienstraße 62**
**80799 München (DE)**

(54) **IMAGE GENERATION DEVICE, IMAGE GENERATION METHOD, AND IMAGE GENERATION PROGRAM**

(57) An image generation device according to the present disclosure includes a light source unit, a pixel array unit, and an image generation unit. The light source unit is configured to change luminous intensity of each of light in a plurality of wavelength bands. The pixel array unit includes a plurality of pixels each having a photoelectric conversion unit is arranged in a row direction and a column direction, and receives light from a target irradiated with light in a plurality of wavelength bands. The image generation unit generates an image having components of the light in a plurality of wavelength bands, on the basis of timing of changing the luminous intensity of each of the light in a plurality of wavelength bands in the light source unit and a result of detection, in the pixel array unit, of the change of the luminous intensity in the light source unit.

FIG.1

EP 4 629 649 A1

## Description

Field

The present disclosure relates to an image generation device, an image generation method, and an image generation program.

Background

For a solid-state imaging element using a complementary metal oxide semiconductor (CMOS) or the like, an asynchronous solid-state imaging element has been proposed that detects, as an event signal, a change in luminance for each pixel in real time (e.g., Patent Literature 1). The solid-state imaging element that detects the event signal for each pixel in this way is also referred to as event-based vision sensor (EVS).

Citation List

Patent Literature

Patent Literature 1: JP 2017-535999 A

Summary

Technical Problem

The present disclosure proposes an image generation device, an image generation method, and an image generation program that enable improvement of convenience of a solid-state imaging element.

Solution to Problem

According to the present disclosure, there is provided an image generation device. The image generation device includes a light source unit, a pixel array unit, and an image generation unit. The light source unit is configured to change luminous intensity of each of light in a plurality of wavelength bands. The pixel array unit includes a plurality of pixels each having a photoelectric conversion unit is arranged in a row direction and a column direction, and receives light from a target irradiated with light in a plurality of wavelength bands. The image generation unit generates an image having components of the light in a plurality of wavelength bands, on the basis of timing of changing the luminous intensity of each of the light in a plurality of wavelength bands in the light source unit and a result of detection, in the pixel array unit, of the change of the luminous intensity in the light source unit.

Brief Description of Drawings

FIG. 1 is a schematic diagram illustrating an exemplary schematic configuration of an image generation device according to a first embodiment.
FIG. 2 is a block diagram illustrating an exemplary system configuration of the image generation device according to the first embodiment.
FIG. 3 is a block diagram illustrating an exemplary schematic configuration of EVS according to the first embodiment.
FIG. 4 is a diagram illustrating an exemplary process performed by the image generation device according to the first embodiment.
FIG. 5 is a graph illustrating a mechanism configured to reproduce gradation in the image generation device according to the first embodiment.
FIG. 6 is a graph illustrating a mechanism configured to reproduce gradation in the image generation device according to the first embodiment.
FIG. 7 is a diagram illustrating an exemplary process performed by the image generation device according to the first embodiment.
FIG. 8 is a diagram illustrating an exemplary process performed by the image generation device according to the first embodiment.
FIG. 9 is a diagram illustrating an exemplary operation of the image generation device according to the first embodiment.

FIG. 10 is a block diagram illustrating an exemplary system configuration of the image generation device according to a first modification of the first embodiment.

FIG. 11 is a diagram illustrating an exemplary operation of the image generation device according to the first modification of the first embodiment.

FIG. 12 is a block diagram illustrating an exemplary system configuration of the image generation device according to a second modification of the first embodiment.

FIG. 13 is a diagram illustrating an exemplary operation of the image generation device according to the second modification of the first embodiment.

FIG. 14 is a block diagram illustrating an exemplary system configuration of the image generation device according to a third modification of the first embodiment.

FIG. 15 is a block diagram illustrating an exemplary system configuration of the image generation device according to a second embodiment.

FIG. 16 is a block diagram illustrating an exemplary schematic configuration of a black-and-white image sensor according to the second embodiment.

FIG. 17 is a diagram illustrating an exemplary process performed by the image generation device according to the second embodiment.

FIG. 18 is a diagram illustrating an exemplary process performed by the image generation device according to the second embodiment.

FIG. 19 is a diagram illustrating an exemplary process performed by the image generation device according to the second embodiment.

FIG. 20 is a flowchart illustrating an exemplary procedure of an image generation process performed by the image generation device according to the first embodiment.

FIG. 21 is a flowchart illustrating an exemplary procedure of an image generation process performed by the image generation device according to the second embodiment.

Description of Embodiments

Hereinafter, embodiments of the present disclosure will be described with reference to the accompanying drawings. Note that the present disclosure is not limited to the following embodiments. Furthermore, the embodiments can be appropriately combined within a range the processing contents have no contradiction. In addition, in the following embodiments, the same portions are denoted by the same reference numerals, and descriptions thereof will not be repeated.

For a solid-state imaging element using a complementary metal oxide semiconductor (CMOS) or the like, an asynchronous solid-state imaging element has been proposed that detects, as an event signal, a change in luminance for each pixel in real time. The solid-state imaging element that detects the event signal for each pixel in this way is also referred to as event-based vision sensor (EVS).

However, the conventional art described above is allowed to generate only a binary event signal for each pixel, and therefore, it is very difficult to generate an image having gradation by the same solid-state imaging element. In other words, in the conventional art described above, there is room for further improvement in the convenience of the solid-state imaging element such as EVS.

Therefore, realization of a technology enabling to overcome the problems described above and improve convenience of the solid-state imaging element is expected.

<First embodiment>

First, a first embodiment will be described in detail with reference to the drawings.

<Exemplary configuration of image generation device>

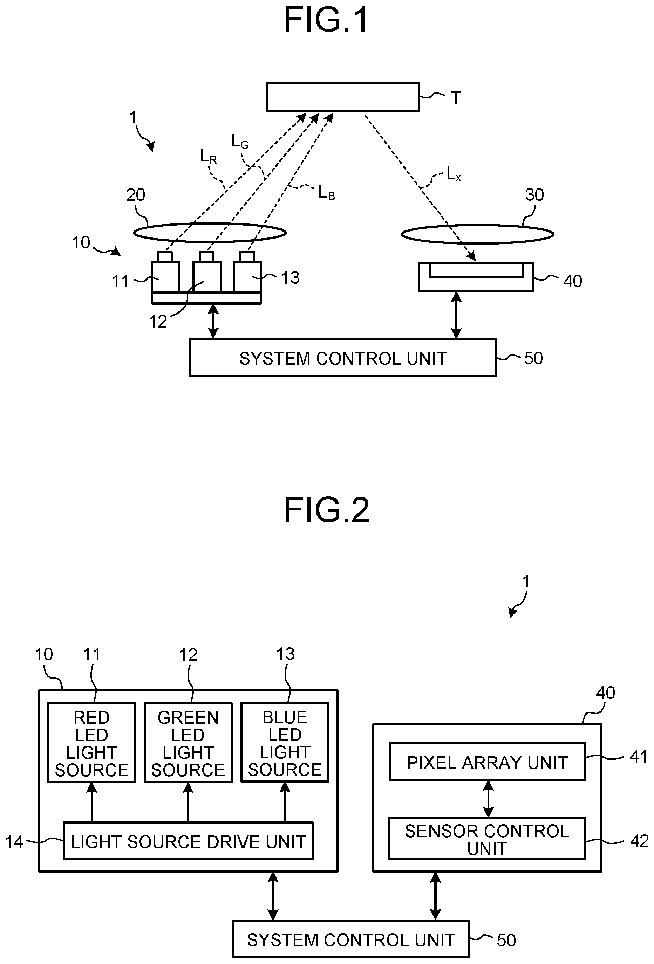

FIG. 1 is a schematic diagram illustrating an exemplary schematic configuration of an image generation device 1 according to the first embodiment, and FIG. 2 is a block diagram illustrating an exemplary system configuration of the image generation device 1 according to the first embodiment.

As illustrated in FIG. 1, the image generation device 1 according to the first embodiment includes a light source unit 10, an irradiation lens 20, an imaging lens 30, an EVS 40, and a system control unit 50. The system control unit 50 is an example of an image generation unit.

As illustrated in FIG. 2, the light source unit 10 includes, for example, a red light emitting diode (LED) light source 11, a green LED light source 12, a blue LED light source 13, and a light source drive unit 14. Alternatively, each of the LED light sources may use a laser diode (LD) in place of the LED to emit light scattered/diffused by an optical system using a scattering plate or the like as necessary.

The red LED light source 11 is an LED light source that emits light in a red wavelength band (hereinafter, also referred to as red light $L_R$ (see FIG. 1)). The green LED light source 12 is an LED light source that emits light in a green wavelength band (hereinafter, also referred to as green light $L_G$ (see FIG. 1)).

The blue LED light source 13 is an LED light source that emits light in a blue wavelength band (hereinafter, also referred to as blue light $L_B$ (see FIG. 1)). The light source drive unit 14 is configured to drive the red LED light source 11, the green LED light source 12, and the blue LED light source 13 independently.

As illustrated in FIG. 1, the irradiation lens 20 is arranged on a side of an emission surface of the light source unit 10 to convert each of the red light $L_R$, the green light $L_G$, and the blue light $L_B$ emitted from the light source unit 10, into irradiation light having a predetermined divergence angle. Note that the irradiation lens 20 may be combined with a folded optical system using a prism or a mirror, or diffusion light from the light source may be directly used as the irradiation light without the irradiation lens 20.

The imaging lens 30 is arranged on a side of a light reception surface of the EVS 40 to form an image of incident light, on the light reception surface of the EVS 40. The incident light can also include reflected light $L_x$ emitted from the light source unit 10 and reflected by a target T.

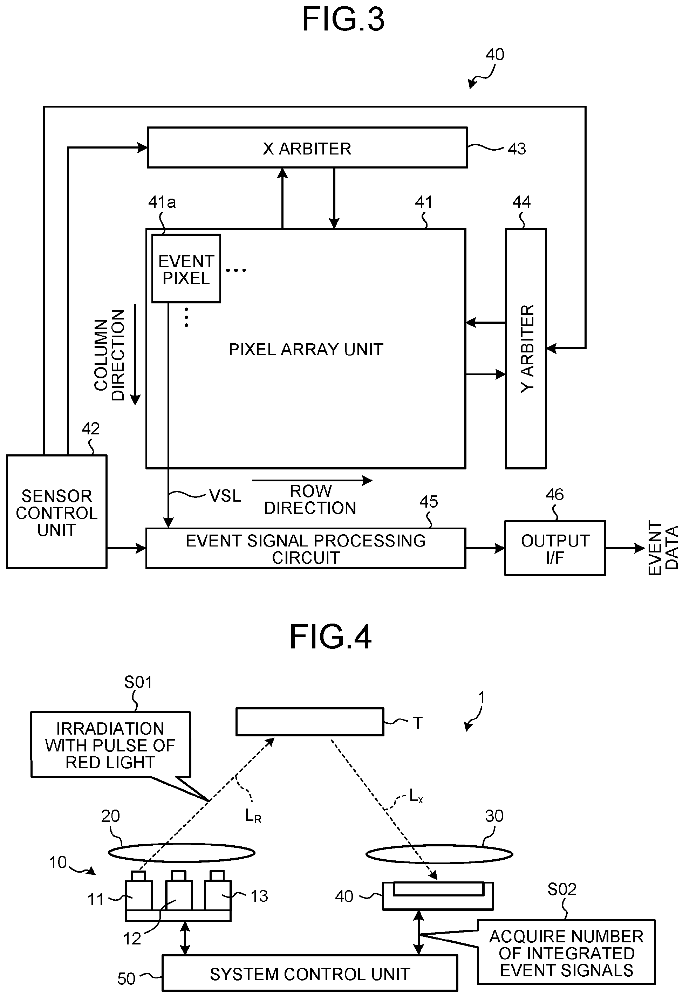

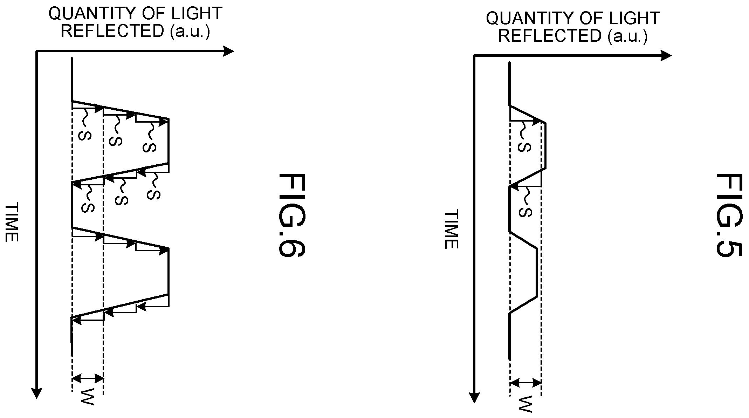

Although detailed description thereof will be made later, the EVS 40 includes, for example, a pixel array unit 41 and a sensor control unit 42, as illustrated in FIG. 2. In the pixel array unit 41, pixels (hereinafter, referred to as event pixels 41a (see FIG. 3)) each detecting an event are arranged to form a two-dimensional lattice. The sensor control unit 42 drives the pixel array unit 41 to generate event data including an event signal S (see FIG. 5) detected by each of the event pixels 41a.

The system control unit 50 includes, for example, a processor (CPU), and drives the red LED light source 11, the green LED light source 12, and the blue LED light source 13, via the light source drive unit 14.

In addition, the system control unit 50 controls the EVS 40 in parallel with control of the light source unit 10, thereby acquiring the event data including the event signal S detected according to a change in luminous intensity in the light source unit 10.

For example, the irradiation light emitted from the light source unit 10 is projected onto the target T through the irradiation lens 20. The projected light is reflected by the target T. Then, the light reflected by the target T passes through the imaging lens 30 and enters the EVS 40.

The EVS 40 receives the light reflected by the target T, generates the event signal S, and generates the event data including the generated event signal S. The event data generated by the EVS 40 is supplied to the system control unit 50. The system control unit 50 performs processing on the event data input from the EVS 40, which is described later.

FIG. 3 is a block diagram illustrating an exemplary schematic configuration of the EVS 40 according to the first embodiment. As illustrated in FIG. 3, the EVS 40 includes the pixel array unit 41, the sensor control unit 42, an X arbiter 43 and a Y arbiter 44, an event signal processing circuit 45, and an output interface (I/F) 46.

The pixel array unit 41 has a configuration in which a plurality of event pixels 41a each detecting an event on the basis of a change in luminance of the incident light is arranged to form a two-dimensional lattice. Each of the event pixels 41a is an example of a pixel.

Note that, in the following description, a row direction refers to an arrangement direction of the pixels in a pixel row (horizontal direction in the drawing), and a column direction refers to an arrangement direction of the pixels in a pixel column (vertical direction in the drawing).

The event pixel 41a includes a photoelectric conversion element that generates a charge according to the luminance of the incident light. When the event pixel 41a detects the change in luminance of the incident light on the basis of a photocurrent flowing out of the photoelectric conversion element, the event pixel 41a outputs a request for reading from itself, to the X arbiter 43 and the Y arbiter 44.

Then, the event pixel 41a outputs the event signal S (see FIG. 5) indicating detection of the event, according to arbitration by the X arbiter 43 and the Y arbiter 44.

The event pixel 41a detects the presence or absence of the event, on the basis of whether the change exceeding a predetermined threshold width W (see FIG. 5) has occurred in the photocurrent according to the luminance of the incident light. For example, the event pixel 41a detects, as the event, the change in luminance exceeding the predetermined threshold width W (positive event) or falling below the predetermined threshold width W (negative event).

When detecting the event, the event pixel 41a outputs a request for permission to output the event signal S indicating the occurrence of the event, to each of the X arbiter 43 and the Y arbiter 44.

Then, the event pixel 41a outputs the event signal S to the event signal processing circuit 45 when receiving a response indicating the permission to output the event signal S, from each of the X arbiter 43 and the Y arbiter 44.

The X arbiter 43 and the Y arbiter 44 arbitrate the request for output of the event signal S supplied from each of the plurality of event pixels 41a. Then, the X arbiter 43 and the Y arbiter 44 transmit a response based on a result of the arbitration (permission/non-permission of the output of the event signal S) and a reset signal resetting the detection of the event, to the event pixel 41a that has output the request.

The event signal processing circuit 45 performs predetermined signal processing on the event signal S input from the event pixel 41a to generate and output the event data.

As described above, the change of the photocurrent generated in the event pixel 41a can also be regarded as a change in quantity of light (change in luminance) entering the photoelectric conversion unit of the event pixel 41a. Therefore, it can also be said that the event is the change in quantity of light (change in luminance) of the event pixel 41a exceeding the predetermined threshold width W.

The event data indicating the occurrence of the event includes at least position information such as coordinates indicating the position of the event pixel 41a where the change in quantity of light as the event has occurred. The event data can include the polarity of the change in quantity of light, in addition to the position information.

The event data output from the event pixel 41a at the timing of occurrence of the event implicitly includes time information indicating the relative time when the event occurs, as long as the interval between pieces of the event data is maintained without changing from the times of occurrence of the events.

However, when the interval between the pieces of the event data is not maintained and changed from the times of occurrence of the events due to storage or the like of the event data in a memory, the time information implicitly included in the event data is lost.

Therefore, before the interval between the pieces of the event data is not maintained without changing from the times of occurrence of the events, the event signal processing circuit 45 may include the time information, such as a time stamp, indicating a relative time or an absolute time when the event has occurred, in the event data.

The sensor control unit 42 includes a timing generator or the like that generates various timing signals. The sensor control unit 42 controls drive of the X arbiter 43, the Y arbiter 44, the event signal processing circuit 45, and the like, on the basis of various timings generated by the timing generator.

The output I/F 46 sequentially outputs the event data output from the event signal processing circuit 45, to the system control unit 50 (see FIG. 2).

<Details of image generation process>

Next, details of the image generation process according to the first embodiment will be described with reference to FIGS. 4 to 9. FIG. 4 is a diagram illustrating an exemplary process performed by the image generation device 1 according to the first embodiment.

As illustrated in FIG. 4, in the first embodiment, the system control unit 50 controls the light source unit 10 first to irradiate the target T with a pulse of red light $L_R$ from the red LED light source 11 (Step S01).

Note that in the present disclosure, "pulse irradiation" may be light irradiation in which light is repeatedly turned on and off, or light irradiation in which high luminous intensity (e.g., luminous intensity of 100%) and low luminous intensity (e.g., luminous intensity of 50%) are repeated.

Furthermore, in parallel with the processing of Step S01, the system control unit 50 controls the EVS 40 to acquire the number of integrated event signals S (see FIG. 5) for each event pixel 41a, the event signals S being generated by the reflected light $L_x$ caused by the red light $L_R$ (Step S02).

Here, a mechanism of the image generation process according to the first embodiment will be described with reference to FIGS. 5 and 6. FIGS. 5 and 6 are graphs each illustrating a mechanism configured to reproduce gradation in the image generation device 1 according to the first embodiment.

In general, the gradation of the image is dark at a portion of the target T having a low reflectance, dark at a portion having a medium reflectance, bright at a portion having a high reflectance, and very bright at a portion having a very high reflectance.

Therefore, as represented by a pulse on the left side of FIG. 5, for example, two event signals S are generated in a single pulse irradiation at the portion having a medium reflectance. Furthermore, as illustrated by a pulse on the right side of FIG. 5, for example, the event signal S may not be stochastically generated at the place having a low reflectance.

Meanwhile, as illustrated in FIG. 6, at the portion having a very high reflectance, for example, more than two event signals S (six signals S in the drawing) are generated in a single pulse irradiation. This is because, as illustrated in FIG. 6, brightness (i.e., the brightness of the reflected light $L_x$) of the irradiation light of the LED actually changes over time, and therefore, a large number of events occur continuously when a quantity of light reflected is very large.

In addition, a process of amplifying an analog signal from the photoelectric conversion element and extracting the analog signal is a transient phenomenon having a time constant with a predetermined value or more, the transient phenomenon gives the effect equivalent to the effect of the quantity of light reflected changing over a longer time, contributing to the continuous occurrence of the large number of events.

Therefore, in the first embodiment, acquiring the number of integrated event signals S generated by the pulse irradiation with the red light $L_R$, for each event pixel 41a (see FIG. 3) makes it possible to reproduce red color gradation for each event pixel 41a.

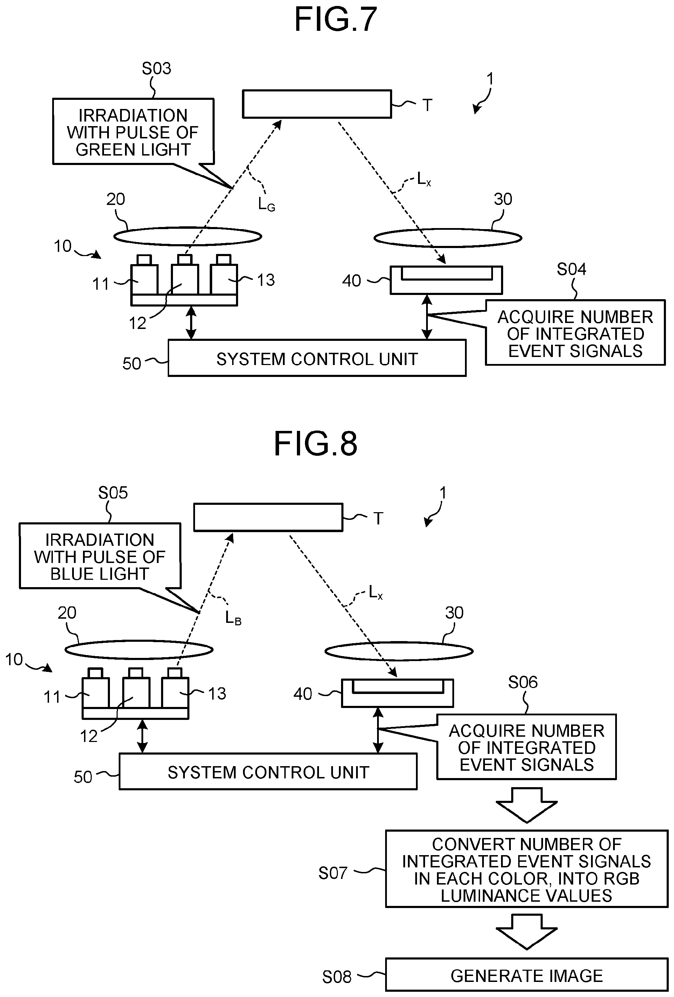

FIGS. 7 and 8 are diagrams each illustrating an exemplary process performed by the image generation device 1 according to the first embodiment. Subsequently to the process of FIG. 4, in the first embodiment, the system control unit 50 controls the light source unit 10 to irradiate the target T with a pulse of green light $L_G$ from the green LED light source 12 (Step S03).

Furthermore, in parallel with the processing of Step S03, the system control unit 50 controls the EVS 40 to acquire the number of integrated event signals S (see FIG. 5) generated by the reflected light $L_x$ caused by the green light $L_G$ (Step S04).

Next, as illustrated in FIG. 8, the system control unit 50 controls the light source unit 10 to irradiate the target T with a pulse of blue light $L_B$ from the blue LED light source 13 (Step S05).

Furthermore, in parallel with the processing of Step S05, the system control unit 50 controls the EVS 40 to acquire the number of integrated event signals S (see FIG. 5) generated by the reflected light $L_x$ caused by the blue light $L_B$ (Step S06).

Next, the system control unit 50 converts the number of integrated event signals S in each color, into RGB luminance values, the event signals S of each color being acquired in the processing described above (Step S07). Then, the system control unit 50 generates an image on the basis of the RGB luminance values (Step S08), and finishes a series of the steps of the image generation process.

Note that, in the image generation process described above, the example has been described in which the target T is irradiated with light in the order of the red light $L_R$, the green light $L_G$, and the blue light $L_B$, but the present disclosure is not limited to this example, and irradiation with light of the respective colors may be performed in any order.

In this way, in the first embodiment, the image having gradation of a plurality of colors (here, three RGB colors) is allowed to be generated using the EVS 40 configured to detect only the event signal S being a binary signal for each event pixel 41a (see FIG. 3). Therefore, according to the first embodiment, the convenience of the EVS 40 can be improved.

Furthermore, in the first embodiment, the gradation of a plurality of colors can be detected in all the event pixels 41a provided in the pixel array unit 41. This configuration makes it possible to reduce occurrence of false color that causes a problem with an image sensor that is configured to only detect a single color for each pixel.

In addition, in the first embodiment, the brightness of ambient light around the target T does not change significantly in a short time, and therefore, the ambient light does not contribute to the occurrence of the event in the EVS 40. In other words, in the first embodiment, similar color images can be generated regardless of the difference in ambient light, and therefore, a color image that is not affected by a color temperature of the ambient light or the like can be generated.

Furthermore, in the first embodiment, the color image can be generated relatively inexpensively as compared with an existing multispectral camera. Furthermore, when laser light such as LD is used for the light source instead of the LED, the laser light having a very narrow frequency width enables generation of a color image having high spectral resolution.

Furthermore, in the first embodiment, the system control unit 50 preferably irradiates the target T with pulsed light of the red light $L_R$, green light $L_G$, and blue light $L_B$ rather than continuous light of red light $L_R$, green light $L_G$, and blue light $L_B$. This configuration allows generation of more event signals S with a large number of pulses of light, and therefore, a color image having good gradation can be generated.

Furthermore, in the first embodiment, the light source drive unit 14 preferably applies light of each color exclusively to the target T. This is because, simultaneous application of light of a plurality of colors makes determination of which light applied causes generation of the event signal S very difficult.

Furthermore, in the first embodiment described above, the example in which the light source unit 10 and the EVS 40 are operated while being synchronized by the system control unit 50 has been described, but the present disclosure is not limited to this example.

For example, the start time and the end time of emission from each LED light source in the light source unit 10 are recorded as the absolute times, and transition of occurrence of the event signal S in the EVS 40 is recorded with time stamps indicating the absolute times.

Then, the system control unit 50 may generate the image by acquiring the transition of the operation of each LED light source and the transition of occurrence of the event signal S in the EVS 40, and separately calculating the number of integrated event signals S in each color, after the operations of the light source unit 10 and the EVS 40 are finished.

This configuration also makes it possible to generate the image having gradation of a plurality of colors by using the EVS 40 configured to detect only the event signal S being a binary signal for each event pixel 41a. Therefore, according to the first embodiment, the convenience of the EVS 40 can be improved.

Note that at this time, for example, the target T may be irradiated with the red light $L_R$, the green light $L_G$, and the blue light $L_B$, with the values of the pulse frequencies or the like of the red LED light source 11, the green LED light source 12, and the blue LED light source 13 different from each other.

This configuration makes it possible for the system control unit 50 to easily acquire timing of irradiation with each of the red light $L_R$, the green light $L_G$, and the blue light $L_B$, from a trigger signal pulse train, when confirming the transition of the operation of each LED light source after the end of the operation of the light source unit 10. Therefore, according to the first embodiment, the image generation process can be easily performed.

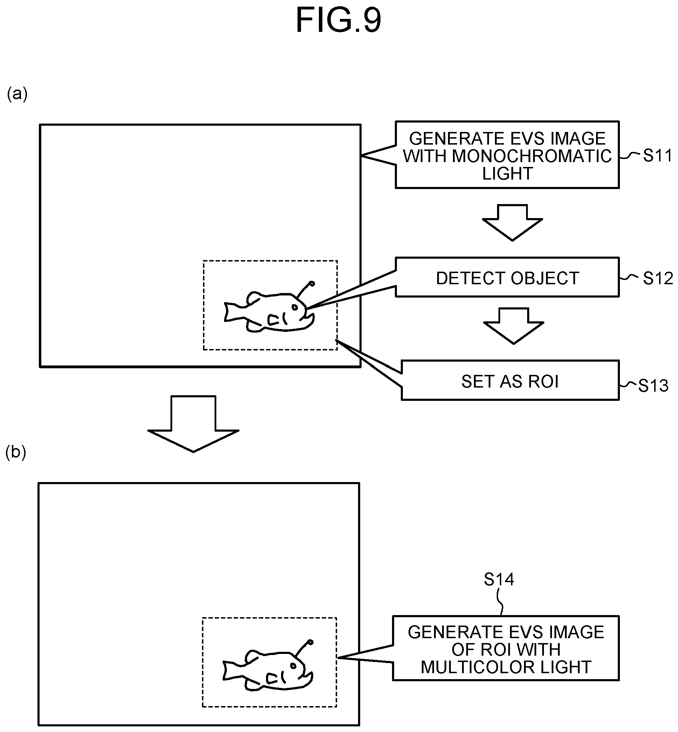

FIG. 9 is a diagram illustrating an exemplary operation of the image generation device 1 according to the first embodiment. In FIG. 9, an application example of the technology of the present disclosure in underwater investigation will be described.

First, as illustrated in (a) of FIG. 9, for an environment with a poor visibility, the system control unit 50 (see FIG. 1) generates an EVS image with one LED light source (i.e., monochromatic light) or an appropriately combined LED light sources of the plurality of LED light sources (Step S11). Note that, in the processing of Step S11, a light source other than the monochromatic light, such as a white LED may be used as necessary.

Then, when an object is detected in a captured region (Step S12), the system control unit 50 sets the region in which the object is detected, as a region of interest (ROI) (Step S13).

Furthermore, as illustrated in (b) of FIG. 9, the system control unit 50 generates an EVS image of the set ROI by using the plurality of LED light sources (i.e., multicolor light) (Step S14). Therefore, the EVS image of the region to which attention is paid can be generated with multicolor light.

In the example of FIG. 9, generation of the EVS image in polychromatic light only within the region to which attention is paid at necessary timing, and non-generation of the EVS image in multicolor light at other timings and regions enable reduction of power consumption of the image generation device 1 and reduction of the capacity of the generated image.

<First modification>

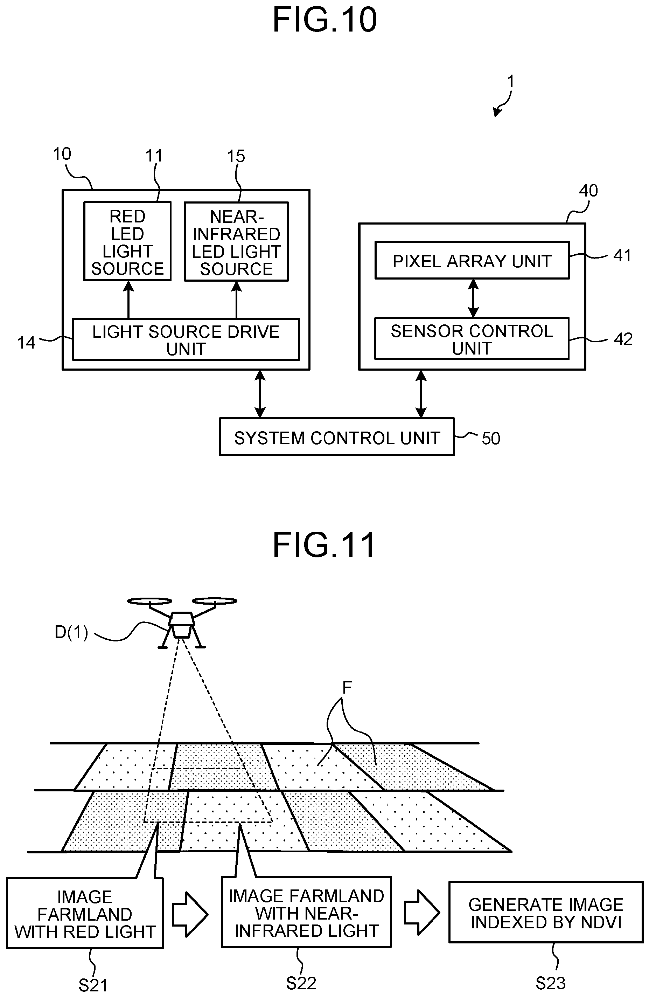

Next, various modifications of the first embodiment will be described with reference to FIGS. 10 to 14. FIG. 10 is a block diagram illustrating an exemplary system configuration of the image generation device 1 according to a first modification of the first embodiment.

As illustrated in FIG. 10, in the first modification, a configuration of the light source unit 10 is different from that of the first embodiment described above. Therefore, in the following examples, portions similar to the portions of the embodiments and the like having been described above are denoted by the same reference numerals, and detailed descriptions thereof may not be repeated.

As illustrated in FIG. 10, in the first modification, the light source unit 10 includes the red LED light source 11 and a near-infrared LED light source 15. The near-infrared LED light source 15 is an LED light source that emits light in a near-infrared wavelength band (hereinafter, also referred to as near-infrared light). Then, the light source drive unit 14 is configured to drive the red LED light source 11 and the near-infrared LED light source 15 independently.

FIG. 11 is a diagram illustrating an exemplary operation of the image generation device 1 according to the first modification of the first embodiment. In FIG. 11, an application example of the technology of the present disclosure in vegetation evaluation of farmland F will be described.

In the example of FIG. 11, for example, the image generation device 1 is mounted on a drone D. Then, the system control unit 50 (see FIG. 10) of the image generation device 1 mounted on the drone D images the farmland F with red light $L_R$ (see FIG. 1) first from above the farmland F (Step S21).

Next, the system control unit 50 images the farmland F with near-infrared light (Step S22). Then, the system control unit 50 generates an image indexed by a normalized difference vegetation index (NDVI) on the basis of the processing of Steps S21 and S22 (Step S23).

The NDVI is an index represented by the following Formula (1), and represents that a value closer to +1 indicates better vegetation.

$$NDVI = (NIR - RED)/(NIR + RED) \qquad\qquad (1)$$

NIR: reflection amount of light in a near-infrared region
RED: reflection amount of light in a red region

Then, in the technology of the present disclosure, it is possible to generate the image that is not affected by the color temperature of the ambient light or the like, as described above. In other words, in the first modification, NDVI can be evaluated without being affected by the ambient light. Therefore, according to the first modification, it is possible to accurately evaluate the vegetation of the farmland F.

<Second modification>

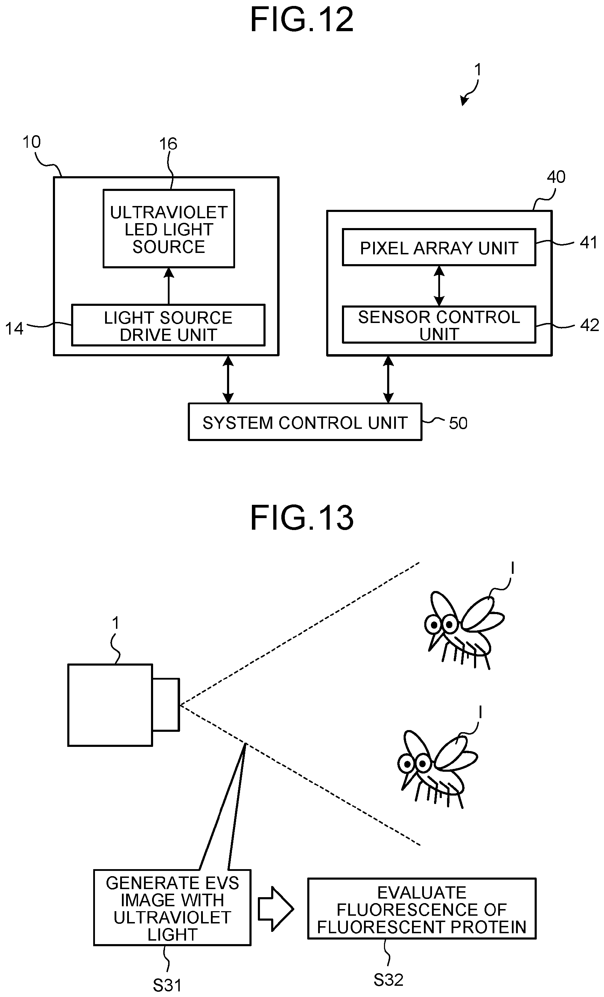

In the first embodiment and the first modification described above, an example of the light source unit 10 that is configured to emit light in a plurality of wavelength bands has been described, but the present disclosure is not limited to these examples. FIG. 12 is a block diagram illustrating an exemplary system configuration of the image generation device 1 according to a second modification of the first embodiment.

As illustrated in FIG. 12, in the second modification, the light source unit 10 includes an ultraviolet LED light source 16. The ultraviolet LED light source 16 is an LED light source that emits light in an ultraviolet wavelength band (hereinafter, also referred to as ultraviolet light). The light source drive unit 14 is configured to drive the ultraviolet LED light source 16.

FIG. 13 is a diagram illustrating an exemplary operation of the image generation device 1 according to the second modification of the first embodiment. In FIG. 13, an application example of the technology of the present disclosure in evaluation of fluorescent protein introduced into an organism I will be described.

In the example of FIG. 13, the system control unit 50 (see FIG. 12) of the image generation device 1 irradiates the organism I with ultraviolet light first and receives fluorescence induced thereby to generate an EVS image of the organism I (Step S31). When the EVS 40 is sensitive to ultraviolet light, an optical filter that blocks ultraviolet light may be installed as necessary. Then, the fluorescence of the fluorescent protein in the organism I is evaluated on the basis of the generated EVS image (Step S32).

Then, in the technology of the present disclosure, it is possible to generate the image that is not affected by the color temperature of the ambient light or the like, as described above. In other words, in the second modification, the presence or absence of the fluorescence in the organism I can be evaluated without being affected by the ambient light. Therefore, according to the second modification, it is possible to accurately evaluate the fluorescence of the fluorescent protein.

Note that in the second modification, the example of use of the ultraviolet light has been described, but the light source that generates the fluorescence can select not only the ultraviolet light but also blue light or light in another wavelength band, according to the characteristic of a fluorescent substance.

<Third modification>

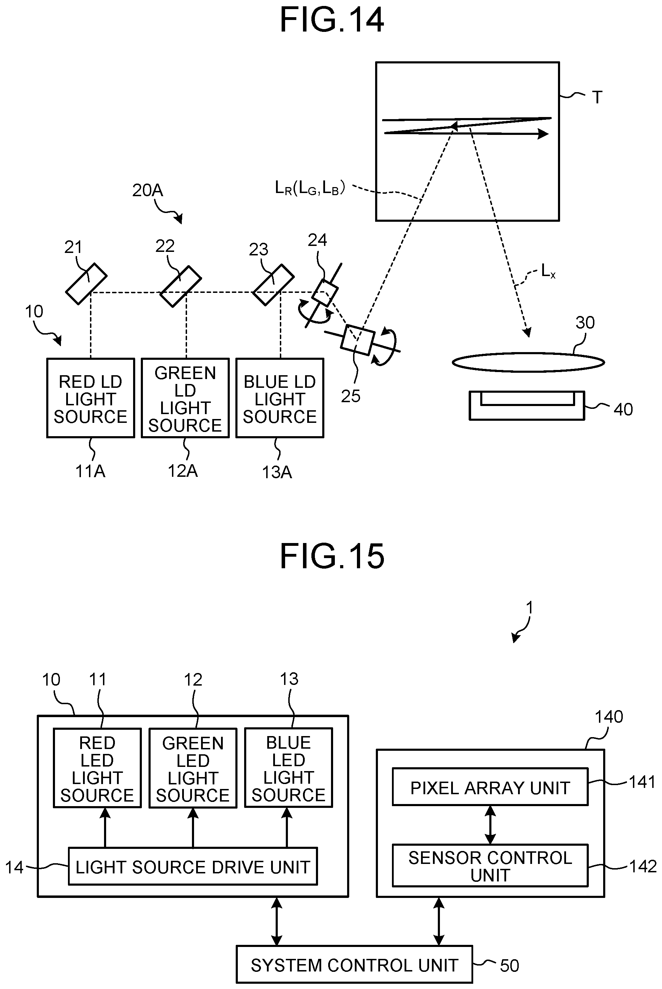

In the first embodiment and the first and second modifications described above, an example in which the light source unit 10 includes various LED light sources has been described, but the present disclosure is not limited to this example. FIG. 14 is a block diagram illustrating an exemplary system configuration of the image generation device 1 according to a third modification of the first embodiment.

As illustrated in FIG. 14, in the third modification, the light source unit 10 includes a red laser diode (LD) light source 11A, a green LD light source 12A, and a blue LD light source 13A.

The red LD light source 11A is an LD light source that emits red light $L_R$. The green LD light source 12A is an LD light source that emits green light $L_G$. The blue LD light source 13A is an LD light source that emits blue light $L_B$. The light source drive unit 14 (see FIG. 1) is configured to drive the red LD light source 11A, the green LD light source 12A, and the blue LD light source 13A independently.

In the third modification, all the light sources include LDs, and the irradiation light (i.e., laser light) has high directivity. Therefore, in the third modification, the target T is irradiated with light while the laser light emitted from the red LD light source 11A, the green LD light source 12A, and the blue LD light source 13A is scanned planarly by an optical system 20A.

The optical system 20A includes optical members 21 to 23, a horizontal scanning member 24, and a vertical scanning member 25. The optical member 21 bends the red light $L_R$ toward a predetermined optical path. The optical member 22 passes the red light $L_R$ on the predetermined optical path and bends the green light $L_G$ toward a predetermined optical path. The optical member 23 passes the red light $L_R$ or the green light $L_G$ on the predetermined optical path, and bends the blue light $L_B$ toward a predetermined optical path.

The horizontal scanning member 24 bends the red light $L_R$ the green light $L_G$, or the blue light $L_B$ so that the red light $L_R$, the green light $L_G$, or the blue light $L_B$ on the predetermined optical path is scanned in a horizontal direction in the target T.

The vertical scanning member 25 bends the red light $L_R$, the green light $L_G$, or the blue light $L_B$ so that the red light $L_R$, the green light $L_G$, or the blue light $L_B$ bent in the horizontal scanning member 24 is scanned in a vertical direction in the target T.

Then, in the third modification, the system control unit 50 (see FIG. 1) controls the light source unit 10 and the optical system 20A to irradiate the target T with the red light $L_R$, the green light $L_G$, or the blue light $L_B$, which is laser light, planarly scanning. The reflected light Lx reflected by the target T enters the EVS 40 through the imaging lens 30.

This configuration makes it possible for the EVS 40 to generate the image having gradation of a plurality of colors (here, three RGB colors). Therefore, according to the third modification, the convenience of the EVS 40 can be improved.

Furthermore, in the third modification, the EVS image is allowed to be generated by the laser light having a very narrow frequency width, enabling generation of the color image having high spectral resolution.

<Second Embodiment>

First, a second embodiment will be described in detail with reference to the drawings.

<Exemplary configuration of image generation device>

FIG. 15 is a block diagram illustrating an exemplary system configuration of the image generation device 1 according to the second embodiment. As illustrated in FIG. 15, the image generation device 1 according to the second embodiment includes the light source unit 10, the irradiation lens 20 (see FIG. 1), the imaging lens 30 (see FIG. 1), a black-and-white image sensor 140, and the system control unit 50.

Configurations of the light source unit 10, the irradiation lens 20, and the imaging lens 30 are similar to those of the first embodiment described above, and thus, detailed description thereof will not be repeated. Note that, as in the first embodiment, the irradiation lens 20 may be combined with the folded optical system, or the irradiation lens 20 itself may be removed.

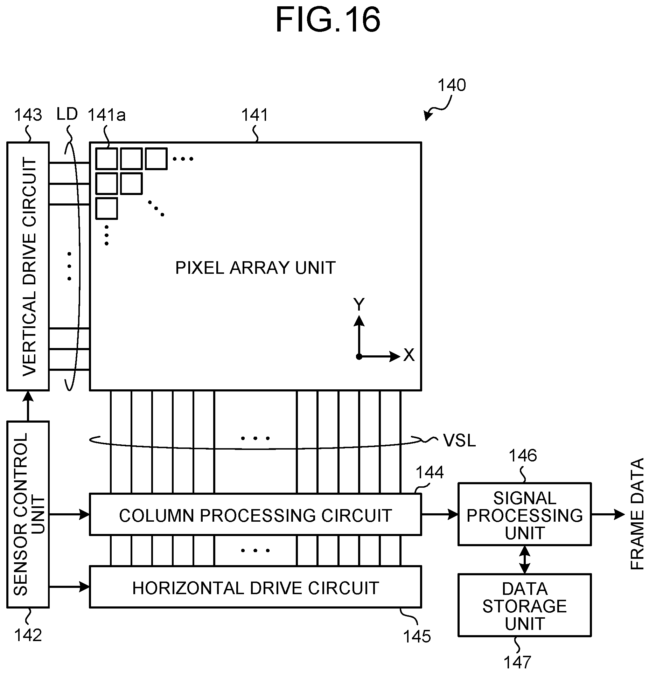

The black-and-white image sensor 140, which will be described in detail later, includes, for example, a pixel array unit 141 and a sensor control unit 142, as illustrated in FIG. 15. In the pixel array unit 141, pixels 141a (see FIG. 16) each having a photoelectric conversion element are arranged to form a two-dimensional lattice.

The system control unit 50 includes, for example, a processor (CPU), and drives the red LED light source 11, the green LED light source 12, and the blue LED light source 13, via the light source drive unit 14.

In addition, the system control unit 50 controls the black-and-white image sensor 140 in parallel with control of the light source unit 10, thereby acquiring image data captured according to a change in luminous intensity in the light source unit 10.

FIG. 16 is a block diagram illustrating an exemplary schematic configuration of the black-and-white image sensor 140 according to the second embodiment.

As illustrated in FIG. 16, the black-and-white image sensor 140 has, for example, a stack structure in which a semiconductor chip on which the pixel array unit 141 is formed and a semiconductor chip on which peripheral circuits are formed are stacked. The peripheral circuits may include, for example, the sensor control unit 142, a vertical drive circuit 143, a column processing circuit 144, and a horizontal drive circuit 145.

The black-and-white image sensor 140 further includes a signal processing unit 146 and a data storage unit 147. The signal processing unit 146 and the data storage unit 147 may be provided on the same semiconductor chip on which the peripheral circuits are provided, or may be provided on a different semiconductor chip.

The pixel array unit 141 has a configuration in which the pixels 141a each having the photoelectric conversion element that generates and accumulates a charge according to a quantity of light received are arranged in a row direction and a column direction, that is, in a matrix to form a two-dimensional lattice.

Note that, in the pixel array unit 141 according to the second embodiment, a color filter or the like is not provided in at least some pixels 141a. Thus, the black-and-white image sensor 140 generates monochrome image data at the positions of some pixels.

In the pixel array unit 141, a pixel drive line LD is wired in the row direction for each pixel row and a vertical signal line VSL is wired in the column direction for each pixel column, for the pixel array in the matrix. The pixel drive line LD transmits a drive signal for driving to read a signal from a pixel.

In FIG. 16, the pixel drive lines LD are illustrated as wiring lines one by one, but are not limited to the wiring lines one by one. The pixel drive line LD has one end that is connected to an output end of the vertical drive circuit 143 corresponding to each row.

The vertical drive circuit 143 includes a shift register, an address decoder, and the like, and drives all of the pixels 141a of the pixel array unit 141 simultaneously or pixels 141a in each row. In other words, the vertical drive circuit 143 constitutes a drive unit that controls the operation of each pixel of the pixel array unit 141, together with the sensor control unit 142 that controls the vertical drive circuit 143.

Although a specific configuration of the vertical drive circuit 143 is not illustrated, a general vertical drive circuit includes two scanning systems of a readout scanning system and a sweep scanning system.

In order to read the signal from the pixel 141a, the readout scanning system selectively scans the pixels 141a of the pixel array unit 141 sequentially for each row. The signal read from each pixel 141a is an analog signal. The sweep scanning system performs sweep scanning earlier than the readout scanning by an exposure time, on a read row on which readout scanning is to be performed by the readout scanning system.

The sweep scanning by the sweep scanning system sweeps out unnecessary charges from the photoelectric conversion elements of the pixels 141a in the read row, whereby the photoelectric conversion element is reset. Then, a so-called electronic shutter operation is performed by sweeping out (resetting) the unnecessary charge in this sweep scanning system. Here, the electronic shutter operation refers to an operation of draining the charges of the photoelectric conversion elements and newly starting exposure (starting accumulation of charges).

The signal read in a readout operation by the readout scanning system corresponds to the quantity of light received after the last readout operation or electronic shutter operation. Then, a period from the read timing of the last readout operation or the sweep timing of the electronic shutter operation, to the read timing of this readout operation is a charge accumulation period (also referred to as an exposure period) in the pixel 141a.

Each of the signals output from the respective pixels 141a in the pixel row selectively scanned by the vertical drive circuit 143 is input to the column processing circuit 144 through each of the vertical signal lines VSL, for each pixel column. The column processing circuit 144 performs, for each pixel column of the pixel array unit 141, predetermined signal processing on the signal output from each pixel in the selected row, through the vertical signal line VSL, and temporarily holds a pixel signal obtained after the signal processing.

Specifically, the column processing circuit 144 performs, as the signal processing, at least noise removal processing, such as correlated double sampling (CDS) processing or double data sampling (DDS) processing.

For example, fixed pattern noise intrinsic to the pixel such as reset noise and threshold variation of an amplifier transistor in the pixel is removed by the CDS processing. The column processing circuit 144 also has, for example, an analog-digital (AD) conversion function to convert the analog pixel signal read from the photoelectric conversion element into a digital signal, and outputs the digital signal.

The horizontal drive circuit 145 includes a shift register, an address decoder, and the like, and sequentially selects a readout circuit of the column processing circuit 144 corresponding to a pixel column (hereinafter, referred to as a pixel circuit). This selective scanning by the horizontal drive circuit 145 causes sequential output of the pixel signal obtained by signal processing for each pixel circuit in the column processing circuit 144.

The sensor control unit 142 includes the timing generator or the like that generates various timing signals. The sensor control unit 142 controls drive of the vertical drive circuit 143, the column processing circuit 144, the horizontal drive circuit 145, and the like, on the basis of various timings generated by the timing generator.

The signal processing unit 146 has at least an arithmetic processing function, and performs various signal processing such as arithmetic processing on the pixel signal output from the column processing circuit 144. For the signal processing in the signal processing unit 146, the data storage unit 147 temporarily stores data necessary for the signal processing.

<Details of image generation process>

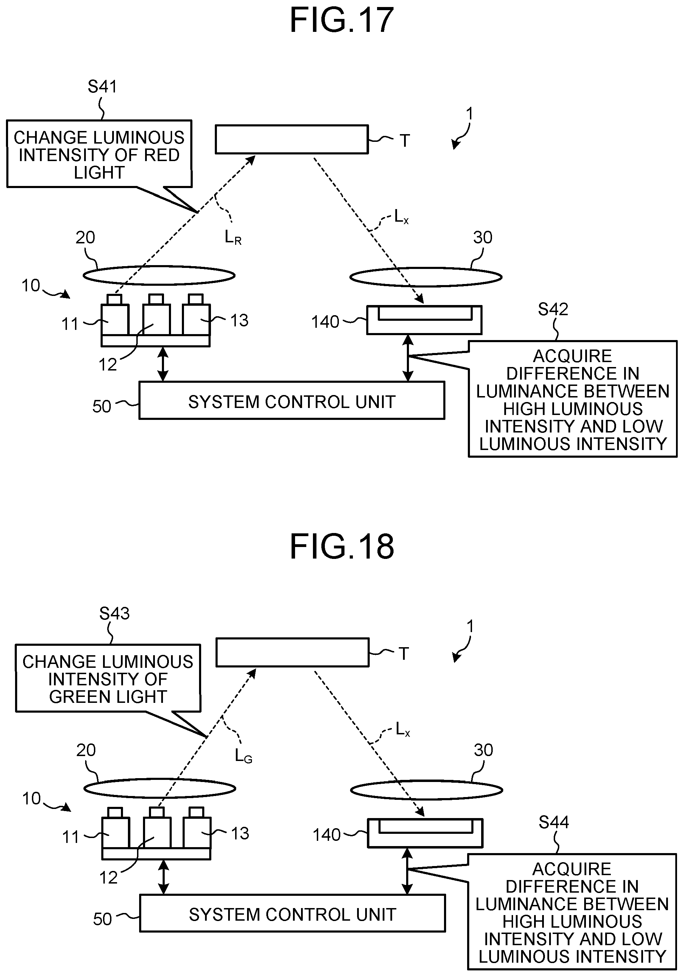

Next, details of the image generation process according to the second embodiment will be described with reference to FIGS. 17 to 19. FIGS. 17 to 19 are diagrams each illustrating an exemplary process performed by the image generation device 1 according to the second embodiment.

As illustrated in FIG. 17, in the second embodiment, the system control unit 50 controls the light source unit 10 first to change the luminous intensity of the red light $L_R$ emitted from the red LED light source 11 toward the target T (Step S41).

Note that, in the present disclosure, "change the luminous intensity of light for irradiation" may be light irradiation in which the luminous intensity is changed between turning on of light and turning off of light, or may be light irradiation in which the luminous intensity is changed between a high luminous intensity (e.g., luminous intensity of 100%) and a low luminous intensity (e.g., luminous intensity of 50%).

Furthermore, in parallel with the processing of Step S41, system control unit 50 controls the black-and-white image sensor 140 to acquire luminance of the red light $L_R$ having a high luminous intensity and luminance of the red light $L_R$ having a low luminous intensity. Then, the system control unit 50 acquires a difference in luminance of the red light $L_R$ between the high luminous intensity and the low luminous intensity (Step S42).

Here, in a region of the target T having a red component, the luminance increases as the luminous intensity of the red light $L_R$ is increased, and therefore, the difference increases in luminance of the red light $L_R$ between the high luminous intensity and the low luminous intensity. On the other hand, in a region of the target T having no red component, the luminance does not increase even if the luminous intensity of the red light $L_R$ is increased, and therefore, the difference decreases in luminance of the red light $L_R$ between the high luminous intensity and the low luminous intensity.

Therefore, in the second embodiment, even the black-and-white image sensor 140 that is configured to acquire only the monochrome image data is allowed to reproduce red gradation for each pixel 141a.

Next, as illustrated in FIG. 18, the system control unit 50 controls the light source unit 10 to change the luminous intensity of the green light $L_G$ emitted from the green LED light source 12 toward the target T (Step S43).

Furthermore, in parallel with the processing of Step S43, the system control unit 50 controls the black-and-white image sensor 140 to acquire luminance of the green light $L_G$ having a high luminous intensity and luminance of the green light $L_G$ having a low luminous intensity. Then, the system control unit 50 acquires a difference in luminance of the green light $L_G$ between the high luminous intensity and the low luminous intensity (Step S44).

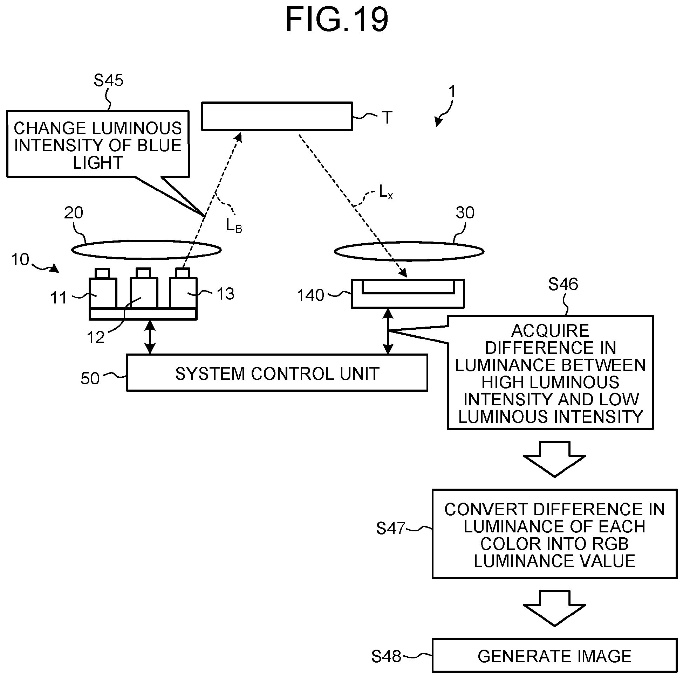

Next, as illustrated in FIG. 19, the system control unit 50 controls the light source unit 10 to change the luminous intensity of the blue light $L_B$ emitted from the blue LED light source 13 toward the target T (Step S45).

Furthermore, in parallel with the processing of Step S45, the system control unit 50 controls the black-and-white image sensor 140 to acquire luminance of the blue light $L_B$ having a high luminous intensity and luminance of the blue light $L_B$ having a low luminous intensity. Then, the system control unit 50 acquires a difference in luminance of the blue light $L_B$ between the high luminous intensity and the low luminous intensity (Step S46).

Next, the system control unit 50 converts the difference in luminance of each color acquired in the processing described above into an RGB luminance value (Step S47). Then, the system control unit 50 generates an image on the basis of the RGB luminance values (Step S48), and finishes a series of the steps of the image generation process.

In this way, in the second embodiment, the image having gradation of a plurality of colors (here, three RGB colors) is allowed to be generated using the black-and-white image sensor 140 that is configured to generate only a monochrome image. Therefore, according to the second embodiment, the convenience of the black-and-white image sensor 140 can be improved.

Furthermore, in the second embodiment, the gradation of the plurality of colors can be detected in all the pixels 141a provided in the pixel array unit 141. This configuration makes it possible to reduce occurrence of false color that causes a problem with an image sensor that is configured to only detect a single color for each pixel.

In addition, in the second embodiment, the brightness of ambient light around the target T does not change significantly in a short time, and therefore, a large change in luminance of the target T is not caused. In other words, in the second embodiment, similar color images can be generated regardless of the difference in ambient light, and therefore, a color image that is not affected by a color temperature of the ambient light or the like can be generated.

Furthermore, in the second embodiment, the color image can be generated relatively inexpensively as compared with an existing multispectral camera. Furthermore, when laser light such as LD is used for the light source instead of the LED, the laser light having a very narrow frequency width enables generation of a color image having high spectral resolution.

In the embodiments described above, an example of generation of a multicolor image by using the EVS 40 or the black-and-white image sensor 140 has been described, but the present disclosure is not limited to this example.

For example, the multicolor image may be generated using an avalanche photo diode (APD) sensor or a single photon avalanche diode (SPAD) sensor having the pixel array unit in which pixels are made of APD or SPAD. Furthermore, in the present disclosure, the multicolor image may be formed using an infrared sensor. This configuration also makes it possible to improve the convenience of these infrared sensor, APD sensor, and SPAD sensor.

Furthermore, in the present disclosure, the pixel array unit may be included in a sensor in which a plurality of types of sensors selected from the EVS, the black-and-white image sensor, the image sensor with the color filter, the infrared sensor, the APD sensor, and the SPAD sensor is combined and arranged.

Then, the multicolor image may be generated using this sensor in which the plurality of types of sensors are combined and arranged. This configuration makes it possible to improve the convenience of the sensor in which the plurality of types of sensors are combined and arranged.

In the embodiments described above, the example in which the system control unit 50 is provided inside the image generation device 1 has been described, but the present disclosure is not limited to this example. For example, the system control unit may be provided outside the image generation device in which the light source unit, the pixel array unit, and the like are provided so that the image generation device and the system control unit may be connected to each other by a network or the like.

<Procedures of image generation process>

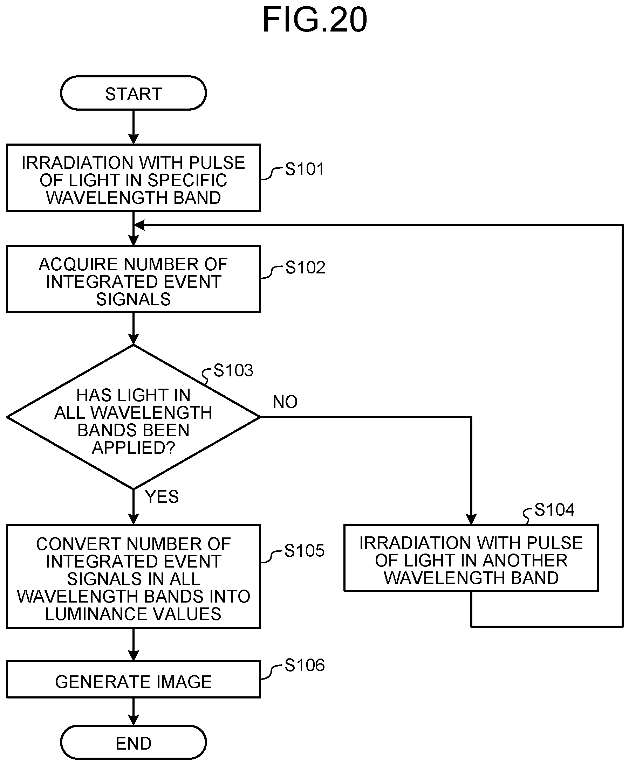

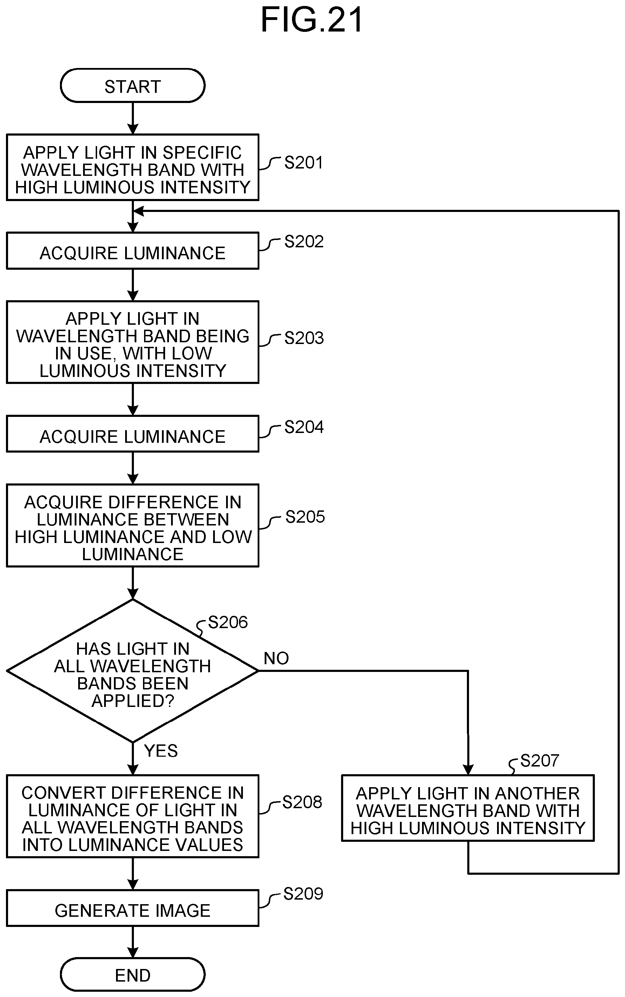

Next, procedures of the image generation process according to the embodiments will be described with reference to FIGS. 20 and 21. FIG. 20 is a flowchart illustrating an exemplary procedure of an image generation process performed by the image generation device 1 according to the first embodiment.

First, the system control unit 50 controls the light source unit 10 to irradiate the target T with a pulse of light in a specific wavelength band (Step S101). Then, the system control unit 50 controls the EVS 40 to acquire the number of integrated event signals S generated due to the light applied to the target T (Step S102).

Next, the system control unit 50 determines whether light in all the wavelength bands has been applied to the target T (Step S103). Then, when the target T is not irradiated with the light in all the wavelength bands (Step S103, No), the system control unit 50 irradiates light in another wavelength band that is not applied to the target T (Step S104), returning to the processing of Step S102.

On the other hand, when the light in all the wavelength bands is applied to the target T (Step S103, Yes), the system control unit 50 converts the number of integrated event signals S generated by the emitted light in all the wavelength bands, into the luminance values for the respective wavelength bands (Step S105).

Finally, the system control unit 50 generates an image on the basis of the converted luminance values (Step S106), and finishes a series of the steps of the image generation process.

FIG. 21 is a flowchart illustrating an exemplary procedure of an image generation process performed by the image generation device 1 according to the second embodiment.

First, the system control unit 50 controls the light source unit 10 to irradiate the target T with light in a specific wavelength band with a high luminous intensity (Step S201). Then, the system control unit 50 controls the black-and-white image sensor 140 to acquire the luminance when the light is applied with a high luminous intensity (Step S202).

Next, the system control unit 50 controls the light source unit 10 to irradiate the target T with the light being in use with a low luminous intensity (Step S203). Then, the system control unit 50 controls the black-and-white image sensor 140 to acquire the luminance when the light is applied with a low luminous intensity (Step S204).

Note that, in the present disclosure, the processing of Steps S203 and S204 described above may be performed before the processing of Steps S201 and S202.

Next, the system control unit 50 acquires a difference in luminance of the light in a specific wavelength band between the high luminous intensity and the low luminous intensity (Step S205).

Next, the system control unit 50 determines whether the target T is irradiated with light in all the wavelength bands (Step S206). Then, when the target T is not irradiated with the light in all the wavelength bands (Step S206, No), the system control unit 50 applies light in another wavelength band that has not been applied to the target T with a high luminous intensity (Step S207), returning to the processing of Step S202.

On the other hand, when the light in all the wavelength bands is applied to the target T (Step S206, Yes), the system control unit 50 converts the difference in luminance of the light in all the wavelength bands emitted, into the luminance values of the respective wavelength bands (Step S208).

Finally, the system control unit 50 generates an image on the basis of the converted luminance values (Step S209), and finishes a series of the steps of the image generation process.

[Effects]

The image generation device 1 according to an embodiment includes the light source unit 10, the pixel array unit 41 (141), and the image generation unit (system control unit 50). The light source unit 10 is configured to change the luminous intensity of each of light in a plurality of wavelength bands. The pixel array unit 41 (141) includes the plurality of pixels having the photoelectric conversion units arranged in the row direction and the column direction, and receives light from the target T irradiated with light in a plurality of wavelength bands. The image generation unit (system control unit 50) generates an image having components of light in a plurality of wavelength bands, on the basis of timing of changing the luminous intensity of each of the light in a plurality of wavelength bands in the light source unit 10 and a result of detection, in the pixel array unit 41, of the change of the luminous intensity in the light source unit 10.

This configuration makes it possible to improve the convenience of the solid-state imaging element.

Furthermore, in the image generation device 1 according to an embodiment, the pixel array unit 41 (141) is included in any one of the EVS 40, the black-and-white image sensor 140, the infrared sensor, the APD sensor, and the SPAD sensor.

This configuration makes it possible to improve the convenience of the solid-state imaging element.

Furthermore, in the image generation device 1 according to an embodiment, the pixel array unit is included in a sensor in which a plurality of types of sensors selected from the EVS, the black-and-white image sensor, the image sensor with the color filter, the infrared sensor, the APD sensor, and the SPAD sensor is combined and arranged.

This configuration makes it possible to improve the convenience of the solid-state imaging element.

Furthermore, in the image generation device 1 according to an embodiment, the pixel array unit 41 is included in any one of the EVS 40, the APD sensor, and the SPAD sensor. The image generation unit generates an image having components of light in a plurality of wavelength bands, on the basis of the timing of changing the luminous intensity of each of the light in a plurality of wavelength bands in the light source unit, and the number of integrated event signals each detected by any one of the EVS sensor, the APD sensor, and the SPAD sensor when the luminous intensity of the light from the light source unit is changed.

This configuration makes it possible to improve the convenience of the EVS 40 and the like.

Furthermore, in the image generation device 1 according to an embodiment, the pixel array unit 141 is included in the black-and-white image sensor 140. Furthermore, the image generation unit generates an image having components of light in a plurality of wavelength bands, on the basis of the timing of changing the luminous intensity of each of the light in a plurality of wavelength bands in the light source unit 10 and the difference in luminance of light detected by the black-and-white image sensor 140 when the luminous intensity is changed in the light source unit 10.

This configuration makes it possible to improve the convenience of the black-and-white image sensor 140.

Furthermore, in the image generation device 1 according to an embodiment, the light source unit 10 is configured to change the luminous intensity of each of light in the red region, light in a green region, and light in a blue region.

This configuration makes it possible to generate a color image of three RGB colors.

Furthermore, in the image generation device 1 according to an embodiment, the light source unit 10 is configured to change the luminous intensity of each of light in the red region and light in the near-infrared region.

This configuration makes it possible to accurately evaluate, for example, the vegetation of the farmland F.

Furthermore, the image generation device 1 according to an embodiment includes the light source unit 10, the EVS 40, and the image generation unit (system control unit 50). The light source unit 10 is configured to change the luminous intensity of light in one wavelength band. The EVS 40 includes the plurality of pixels (the event pixels 41a) each detecting a change in luminance of the incident light and outputting the event signal S is arranged in the row direction and the column direction, and receives light from the target T irradiated with light in one wavelength band. The image generation unit (system control unit 50) generates an image on the basis of the timing of changing the luminous intensity of light in one wavelength band in the light source unit 10 and the number of integrated event signals S each detected by the EVS 40 when the luminous intensity of the light is changed in the light source unit 10.

This configuration makes it possible to improve the convenience of the EVS 40.

Furthermore, in the image generation device 1 according to an embodiment, the light source unit 10 is configured change the luminous intensity of light in the ultraviolet region.

This configuration makes it possible to accurately evaluate, for example, the fluorescence of the fluorescent protein in the organism I.

Furthermore, the image generation device 1 according to an embodiment includes the light source unit 10, the pixel array unit 41 (141), and the image generation unit (system control unit 50). The light source unit 10 is configured to change the luminous intensity of light in one wavelength band. The pixel array unit 41 (141) includes the plurality of pixels having the photoelectric conversion units arranged in the row direction and the column direction, and receives light from the target T irradiated with light in one wavelength band. The image generation unit (system control unit 50) generates an image on the basis of the timing of changing the luminous intensity of light in one wavelength band in the light source unit 10 and a result of detection, in the pixel array unit 41 (141), of the change of the luminous intensity in the light source unit 10.

This configuration makes it possible to improve the convenience of the solid-state imaging element.

An image generation method according to an embodiment includes a luminous intensity changing step (Steps S101, S201, and S203), a light reception step (Steps S102, S202, and S204), and a generation step (Steps S106 and S209). In the luminous intensity changing step (Steps S101, S201, and S203), the luminous intensity of each of light in a plurality of wavelength bands is changed. In the light reception step (Steps S102, S202, and S204), light from the target T irradiated with the light in a plurality of wavelength bands is received. In the generation step, an image having components of light in a plurality of wavelength bands is generated, on the basis of timing of changing the luminous intensity of each of the light in a plurality of wavelength bands in the luminous intensity changing step and a result of detection, performed during the light reception step, of change of the luminous intensity in the luminous intensity changing step.

This configuration makes it possible to improve the convenience of the solid-state imaging element.

In addition, an image generation program according to an embodiment causes the image generation device 1 to execute a luminous intensity changing procedure, a light reception procedure, and a generation procedure. In the luminous intensity changing procedure, the luminous intensity of each of light in a plurality of wavelength bands is changed. In the light reception procedure, light from the target T irradiated with the light in a plurality of wavelength bands is received. In the generation procedure, an image having components of light in a plurality of wavelength bands is generated, on the basis of timing of changing the luminous intensity of each of the light in a plurality of wavelength bands in the luminous intensity changing procedure and a result of detection, performed during the light reception procedure, of change of the luminous intensity in the luminous intensity changing procedure.

This configuration makes it possible to improve the convenience of the solid-state imaging element.

The embodiments of the present disclosure have been described above, but the technical scope of the present disclosure is not limited to the embodiments described above, and various modifications and alterations can be made without departing from the spirit and scope of the present disclosure. Moreover, the component elements of different embodiments and modifications may be suitably combined with each other.

Furthermore, the effects described herein are merely examples, and the present disclosure is not limited to the effects but may have other effects.

Note that the present technology can also have the following configurations.

(1) An image generation device comprising:

a light source unit that enables changing luminous intensity of each of light in a plurality of wavelength bands;
a pixel array unit in which a plurality of pixels each having a photoelectric conversion unit is arranged in a row direction and a column direction and that receives light from a target irradiated with the light in a plurality of wavelength bands; and
an image generation unit that generates an image having components of the light in a plurality of wavelength bands, based on timing of changing the luminous intensity of each of the light in a plurality of wavelength bands in the light source unit and a result of detection, in the pixel array unit, of the change of the luminous intensity in the light source unit.

(2) The image generation device according to the above (1), wherein
the pixel array unit is included in any one of an event-based vision sensor (EVS), a black-and-white image sensor, an infrared sensor, an avalanche photo diode (APD) sensor, and a single-photon avalanche diode (SPAD) sensor.

(3) The image generation device according to the above (1), wherein
the pixel array unit is included in a sensor in which a plurality of types of sensors selected from EVS, a black-and-white image sensor, an image sensor with a color filter, an infrared sensor, an APD sensor, and a SPAD sensor is combined and arranged.

(4) The image generation device according to the above (1) or (2), wherein

the pixel array unit is included in any one of an EVS, an APD sensor, and a SPAD sensor, and
the image generation unit generates the image having components of the light in a plurality of wavelength bands, based on the timing of changing the luminous intensity of each of the light in a plurality of wavelength bands in the light source unit and the number of integrated event signals each being detected by any one of the EVS, the APD sensor, and the SPAD sensor when the luminous intensity is changed in the light source unit.

(5) The image generation device according to the above (1) or (2), wherein

the pixel array unit is included in any one of a black-and-white image sensor and an infrared sensor, and
the image generation unit generates the image having components of the light in a plurality of wavelength bands, based on the timing of changing the luminous intensity of each of the light in a plurality of wavelength bands in the light source unit and a difference in luminance detected by any one of the black-and-white image sensor and the infrared sensor when the luminous intensity is changed in the light source unit.

(6) The image generation device according to any one of the above (1) to (5), wherein
the light source unit enables changing luminous intensity of each of light in a red region, light in a green region, and light in a blue region.

(7) The image generation device according to any one of the above (1) to (5), wherein
the light source unit enables changing luminous intensity of each of light in a red region and light in a near-infrared region.

(8) An image generation device comprising:

a light source unit that enables changing luminous intensity of light in one wavelength band;
EVS in which a plurality of pixels each detecting a change in luminance of incident light and outputting an event signal is arranged in a row direction and a column direction and that receives light from a target irradiated with the light in one wavelength band; and
an image generation unit that generates an image, based on timing of changing the luminous intensity of the light in one wavelength band in the light source unit and the number of integrated event signals each detected by the EVS when the luminous intensity is changed in the light source unit.

(9) The image generation device according to the above (8), wherein
the light source unit enables changing luminous intensity of light in an ultraviolet region.

(10) An image generation device comprising:

a light source unit that enables changing luminous intensity of light in one wavelength band;
a pixel array unit in which a plurality of pixels each having a photoelectric conversion unit is arranged in a row direction and a column direction and that receives light from a target irradiated with the light in one wavelength band; and
an image generation unit that generates an image, based on timing of changing the luminous intensity of the light in one wavelength band in the light source unit and a result of detection, in the pixel array unit, of the change of the luminous intensity in the light source unit.

(11) An image generation method comprising:

a luminous intensity changing step of changing luminous intensity of each of light in a plurality of wavelength bands;
a light reception step of receiving light from a target irradiated with the light in a plurality of wavelength bands; and
a generation step of generating an image having components of the light in a plurality of wavelength bands, based on timing of changing the luminous intensity of each of the light in a plurality of wavelength bands in the luminous intensity changing step and a result of detection, performed during the light reception step, of change of the luminous intensity in the luminous intensity changing step.

(12) The image generation method according to the above (11), wherein
the light reception step is performed by any one of an event-based vision sensor (EVS), a black-and-white image sensor, an infrared sensor, an avalanche photo diode (APD) sensor, and a single-photon avalanche diode (SPAD) sensor.
(13) The image generation method according to the above (11), wherein
the light reception step is performed by a sensor in which a plurality of types of sensors selected from EVS, a black-and-white image sensor, an image sensor with a color filter, an infrared sensor, an APD sensor, and a SPAD sensor is combined and arranged.
(14) The image generation method according to the above (11) or (12), wherein

the light reception step is performed by any one of an EVS sensor, an APD sensor, and a SPAD sensor, and in the generation step, an image having components of the light in a plurality of wavelength bands is generated on the basis of timing of changing luminous intensity of each of the light in a plurality of wavelength bands in the luminous intensity changing step, and the number of integrated event signals each detected by any of the EVS sensor, the APD sensor, and the SPAD sensor when the luminous intensity is changed in the luminous intensity changing step.

(15) The image generation method according to the above (11) or (12), wherein

the light reception step is performed by any one of a black-and-white image sensor and an infrared sensor, and in the generation step, an image having components of the light in a plurality of wavelength bands is generated on the basis of timing of changing luminous intensity of each of the light in the plurality of wavelength bands in the luminous intensity changing step, and a difference in luminance detected by any one of the black-and-white image sensor and the infrared sensor when the luminous intensity is changed in the luminous intensity changing step.

(16) The image generation method according to any of the above (11) to (15), wherein
in the luminous intensity changing step, luminous intensity of each of light in a red region, light in a green region, and light in a blue region is changed.
(17) The image generation method according to any of the above (11) to (15), wherein
in the luminous intensity changing step, luminous intensity of each of light in a red region and light in a near-infrared region is changed.
(18) An image generation method comprising:

a luminous intensity changing step of changing luminous intensity of light in one wavelength band;
a light reception step of receiving light from a target irradiated with the light in one wavelength band by EVS; and
a generation step of generating an image on the basis of timing of changing luminous intensity of the light in one wavelength band in the luminous intensity changing step and the number of integrated event signals each detected by the EVS when the luminous intensity is changed in the luminous intensity changing step.

(19) The image generation method according to the above (18), wherein
in the luminous intensity changing step, luminous intensity of light in an ultraviolet region is changed.
(20) An image generation method comprising:

a luminous intensity changing step of changing luminous intensity of light in one wavelength band;
a light reception step of receiving light from a target irradiated with the light in one wavelength band; and
a generation step of generating an image on the basis of timing of changing luminous intensity of the light in one wavelength band in the luminous intensity changing step and a result of detection, performed during the light reception step, of change of the luminous intensity in the luminous intensity changing step.

(21) An image generation program causing an image generation device to perform:

a luminous intensity changing procedure of changing luminous intensity of each of light in a plurality of wavelength bands;
a light reception procedure of receiving light from a target irradiated with the light in a plurality of wavelength bands; and

a generation procedure of generating an image having components of the light in a plurality of wavelength bands, based on timing of changing the luminous intensity of each of the light in a plurality of wavelength bands in the luminous intensity changing procedure and a result of detection, performed during the light reception procedure, of change of the luminous intensity in the luminous intensity changing procedure.

(22) The image generation program according to the above (21), wherein

the light reception procedure is performed by any one of an event-based vision sensor (EVS), a black-and-white image sensor, an infrared sensor, an avalanche photo diode (APD) sensor, and a single-photon avalanche diode (SPAD) sensor.

(23) The image generation program according to the above (21), wherein

the light reception procedure is performed by a sensor in which a plurality of types of sensors selected from EVS, a black-and-white image sensor, an image sensor with a color filter, an infrared sensor, an APD sensor, and a SPAD sensor is combined and arranged.

(24) The image generation program according to the above (21) or (22), wherein

the light reception procedure is performed by any one of an EVS sensor, an APD sensor, and a SPAD sensor, and in the generation procedure, an image having components of the light in a plurality of wavelength bands is generated on the basis of timing of changing luminous intensity of each of the light in the plurality of wavelength bands in the luminous intensity changing procedure, and the number of integrated event signals each being detected by any of the EVS sensor, the APD sensor, and the SPAD sensor when the luminous intensity is changed in the luminous intensity changing procedure.

(25) The image generation program according to the above (21) or (22), wherein

the light reception procedure is performed by any one of a black-and-white image sensor and an infrared sensor, and

in the generation procedure, an image having components of the light in a plurality of wavelength bands is generated on the basis of timing of changing luminous intensity of each of the light in the plurality of wavelength bands in the luminous intensity changing procedure, and a difference in luminance detected by any one of the black-and-white image sensor and the infrared sensor when the luminous intensity is changed in the luminous intensity changing procedure.

(26) The image generation program according to any of the above (21) to (25), wherein

in the luminous intensity changing procedure, luminous intensity of each of light in a red region, light in a green region, and light in a blue region is changed.

(27) The image generation program according to any of the above (21) to (25), wherein

in the luminous intensity changing procedure, luminous intensity of each of light in a red region and light in a near-infrared region is changed.

(28) An image generation program comprising:

a luminous intensity changing procedure of changing luminous intensity of light in one wavelength band;

a light reception procedure of receiving light from a target irradiated with the light in one wavelength band by EVS; and

a generation procedure of generating an image on the basis of timing of changing luminous intensity of the light in one wavelength band in the luminous intensity changing procedure and the number of integrated event signals each being detected by the EVS when the luminous intensity is changed in the luminous intensity changing procedure.

(29) The image generation program according to the above (28), wherein

in the luminous intensity changing procedure, luminous intensity of light in an ultraviolet region is changed.

(30) An image generation program comprising:

a luminous intensity changing procedure of changing luminous intensity of light in one wavelength band;

a light reception procedure of receiving light from a target irradiated with the light in one wavelength band; and

a generation procedure of generating an image on the basis of timing of changing luminous intensity of the light in one wavelength band in the luminous intensity changing procedure and a result of detection, performed during the light reception procedure, of change of the luminous intensity in the luminous intensity changing procedure.

EP 4 629 649 A1

Reference Signs List

1 IMAGE GENERATION DEVICE

10 LIGHT SOURCE UNIT

11 RED LED LIGHT SOURCE

12 GREEN LED LIGHT SOURCE

13 BLUE LED LIGHT SOURCE

15 NEAR-INFRARED LED LIGHT SOURCE

16 ULTRAVIOLET LED LIGHT SOURCE

40 EVS

41 PIXEL ARRAY UNIT

41a EVENT PIXEL (EXAMPLE OF PIXEL)

50 SYSTEM CONTROL UNIT (EXAMPLE OF IMAGE GENERATION UNIT)

140 BLACK-AND-WHITE IMAGE SENSOR

141 PIXEL ARRAY UNIT

S EVENT SIGNAL

T TARGET

**Claims**

1. An image generation device comprising:

   a light source unit that enables changing luminous intensity of each of light in a plurality of wavelength bands;
   a pixel array unit in which a plurality of pixels each having a photoelectric conversion unit is arranged in a row direction and a column direction and that receives light from a target irradiated with the light in a plurality of wavelength bands; and
   an image generation unit that generates an image having components of the light in a plurality of wavelength bands, based on timing of changing the luminous intensity of each of the light in a plurality of wavelength bands in the light source unit and a result of detection, in the pixel array unit, of the change of the luminous intensity in the light source unit.

2. The image generation device according to claim 1, wherein
   the pixel array unit is included in any one of an event-based vision sensor (EVS), a black-and-white image sensor, an infrared sensor, an avalanche photo diode (APD) sensor, and a single-photon avalanche diode (SPAD) sensor.

3. The image generation device according to claim 1, wherein
   the pixel array unit is included in a sensor in which a plurality of types of sensors selected from EVS, a black-and-white image sensor, an image sensor with a color filter, an infrared sensor, an APD sensor, and a SPAD sensor is combined and arranged.

4. The image generation device according to claim 1, wherein

the pixel array unit is included in any one of an EVS, an APD sensor, and a SPAD sensor, and
the image generation unit generates the image having components of the light in a plurality of wavelength bands, based on the timing of changing the luminous intensity of each of the light in a plurality of wavelength bands in the light source unit and the number of integrated event signals each being detected by any one of the EVS, the APD sensor, and the SPAD sensor when the luminous intensity is changed in the light source unit.

5.  The image generation device according to claim 1, wherein

the pixel array unit is included in any one of a black-and-white image sensor and an infrared sensor, and
the image generation unit generates the image having components of the light in a plurality of wavelength bands, based on the timing of changing the luminous intensity of each of the light in a plurality of wavelength bands in the light source unit and a difference in luminance detected by any one of the black-and-white image sensor and the infrared sensor when the luminous intensity is changed in the light source unit.

6.  The image generation device according to claim 1, wherein
the light source unit enables changing luminous intensity of each of light in a red region, light in a green region, and light in a blue region.

7.  The image generation device according to claim 1, wherein
the light source unit enables changing luminous intensity of each of light in a red region and light in a near-infrared region.

8.  An image generation device comprising:

a light source unit that enables changing luminous intensity of light in one wavelength band;
EVS in which a plurality of pixels each detecting a change in luminance of incident light and outputting an event signal is arranged in a row direction and a column direction and that receives light from a target irradiated with the light in one wavelength band; and
an image generation unit that generates an image, based on timing of changing the luminous intensity of the light in one wavelength band in the light source unit and the number of integrated event signals each detected by the EVS when the luminous intensity is changed in the light source unit.

9.  The image generation device according to claim 8, wherein
the light source unit enables changing luminous intensity of light in an ultraviolet region.

10. An image generation device comprising:

a light source unit that enables changing luminous intensity of light in one wavelength band;
a pixel array unit in which a plurality of pixels each having a photoelectric conversion unit is arranged in a row direction and a column direction and that receives light from a target irradiated with the light in one wavelength band; and
an image generation unit that generates an image, based on timing of changing the luminous intensity of the light in one wavelength band in the light source unit and a result of detection, in the pixel array unit, of the change of the luminous intensity in the light source unit.

11. An image generation method comprising:

a luminous intensity changing step of changing luminous intensity of each of light in a plurality of wavelength bands;
a light reception step of receiving light from a target irradiated with the light in a plurality of wavelength bands; and
a generation step of generating an image having components of the light in a plurality of wavelength bands, based on timing of changing the luminous intensity of each of the light in a plurality of wavelength bands in the luminous intensity changing step and a result of detection, performed during the light reception step, of change of the luminous intensity in the luminous intensity changing step.

12. An image generation program causing an image generation device to perform:

a luminous intensity changing procedure of changing luminous intensity of each of light in a plurality of wavelength bands;

a light reception procedure of receiving light from a target irradiated with the light in a plurality of wavelength bands; and

a generation procedure of generating an image having components of the light in a plurality of wavelength bands, based on timing of changing the luminous intensity of each of the light in a plurality of wavelength bands in the luminous intensity changing procedure and a result of detection, performed during the light reception procedure, of change of the luminous intensity in the luminous intensity changing procedure.

# FIG.1

# FIG.2

# FIG.3

# FIG.4

# FIG.5

# FIG.6

# FIG.7

S03

IRRADIATION
WITH PULSE OF
GREEN LIGHT

T

1

$L_G$

$L_x$

20

30

10

11

12

13

40

S04

ACQUIRE NUMBER
OF INTEGRATED
EVENT SIGNALS

50

SYSTEM CONTROL UNIT

# FIG.8

S05

IRRADIATION
WITH PULSE OF
BLUE LIGHT

T

1

$L_B$

$L_x$

20

30

10

11

12

13

40

S06

ACQUIRE NUMBER
OF INTEGRATED
EVENT SIGNALS

50

SYSTEM CONTROL UNIT

S07

CONVERT NUMBER OF
INTEGRATED EVENT SIGNALS
IN EACH COLOR, INTO RGB
LUMINANCE VALUES

S08

GENERATE IMAGE

# FIG.9

(a)

GENERATE EVS IMAGE
WITH MONOCHROMATIC
LIGHT — S11

DETECT OBJECT — S12

SET AS ROI — S13

(b)

S14

GENERATE EVS IMAGE
OF ROI WITH
MULTICOLOR LIGHT

# FIG.10

```
┌─ 10          ┌─ 11        ┌─ 15
│              │            │
┌──────────────────────────────────────┐        ┌───────────────────────────────────┐  ┌─ 40
│  ┌─────────────┐  ┌─────────────┐     │        │                              ┌─ 41 │
│  │    RED      │  │   NEAR-     │     │        │  ┌─────────────────────────┐        │
│  │    LED      │  │  INFRARED   │     │        │  │   PIXEL ARRAY UNIT      │────────┤
│  │   LIGHT     │  │ LED LIGHT   │     │        │  └─────────────────────────┘        │
│  │   SOURCE    │  │   SOURCE    │     │        │            ↕                        │
│  └─────────────┘  └─────────────┘     │        │  ┌─────────────────────────┐  ┌─ 42 │
│         ↑               ↑             │        │  │   SENSOR CONTROL        │────────┤
│  ┌──────────────────────────────┐     │        │  │       UNIT              │        │
│  │   LIGHT SOURCE DRIVE          │     │        │  └─────────────────────────┘        │
│  │        UNIT                   │     │        │                                     │
│  └──────────────────────────────┘     │        └───────────────────────────────────┘
└──────────────────────────────────────┘
```

RED LED LIGHT SOURCE / NEAR-INFRARED LED LIGHT SOURCE / LIGHT SOURCE DRIVE UNIT / PIXEL ARRAY UNIT / SENSOR CONTROL UNIT

SYSTEM CONTROL UNIT ~ 50

# FIG.11

D(1)

F

| IMAGE FARMLAND WITH RED LIGHT | ⇒ | IMAGE FARMLAND WITH NEAR-INFRARED LIGHT | ⇒ | GENERATE IMAGE INDEXED BY NDVI |

S21          S22          S23

# FIG.12

```
┌─ 10                         16
│  ┌──────────────────────┐
│  │   ULTRAVIOLET        │
│  │   LED LIGHT          │
│  │   SOURCE             │
│  └──────────────────────┘
│         ▲
│  ┌──────────────────────┐
│  │   LIGHT SOURCE       │
│  │   DRIVE UNIT         │
│  └──────────────────────┘
14
```

```
┌─ 40
│  ┌──────────────────────┐── 41
│  │   PIXEL ARRAY UNIT   │
│  └──────────────────────┘
│         ↕
│  ┌──────────────────────┐── 42
│  │   SENSOR CONTROL     │
│  │   UNIT               │
│  └──────────────────────┘
```

```
         ┌──────────────────────────────┐
         │   SYSTEM CONTROL UNIT        │── 50
         └──────────────────────────────┘
```

# FIG.13

GENERATE EVS
IMAGE WITH
ULTRAVIOLET
LIGHT

S31

⇒

EVALUATE
FLUORESCENCE OF
FLUORESCENT PROTEIN

S32

# FIG.14

# FIG.15

# FIG.16

# FIG.17

S41

CHANGE LUMINOUS
INTENSITY OF RED
LIGHT

T

1

$L_R$

$L_X$

20

30

10

11    13

12

140

S42

SYSTEM CONTROL UNIT

50

ACQUIRE
DIFFERENCE IN
LUMINANCE BETWEEN
HIGH LUMINOUS
INTENSITY AND LOW
LUMINOUS INTENSITY

# FIG.18

S43

CHANGE LUMINOUS
INTENSITY OF
GREEN LIGHT

T

1

$L_G$

$L_X$

20

30

10

11    13

12

140

S44

SYSTEM CONTROL UNIT

50

ACQUIRE
DIFFERENCE IN
LUMINANCE BETWEEN
HIGH LUMINOUS
INTENSITY AND LOW
LUMINOUS INTENSITY

# FIG.19

S45

CHANGE LUMINOUS
INTENSITY OF BLUE
LIGHT

T

1

L$_X$

L$_B$

20

10

30

11

12

13

140

S46

ACQUIRE
DIFFERENCE IN
LUMINANCE BETWEEN
HIGH LUMINOUS
INTENSITY AND LOW
LUMINOUS INTENSITY

50

SYSTEM CONTROL UNIT

S47

CONVERT DIFFERENCE IN
LUMINANCE OF EACH
COLOR INTO RGB
LUMINANCE VALUE

S48

GENERATE IMAGE

# FIG.20

```
                    ┌─────────────┐
                    │    START    │
                    └──────┬──────┘
                           │
                           ▼
        ┌──────────────────────────────┐
        │  IRRADIATION WITH PULSE        │  ⌐S101
        │  OF LIGHT IN SPECIFIC          │
        │  WAVELENGTH BAND               │
        └──────────────┬─────────────────┘
                       │
                       ▼
        ┌──────────────────────────────┐
        │  ACQUIRE NUMBER OF            │  ⌐S102
        │  INTEGRATED EVENT            │
        │  SIGNALS                     │
        └──────────────┬─────────────────┘
                       │
                       ▼
              ╱─────────────────╲        ⌐S103
            ╱                     ╲
          ╱   HAS LIGHT IN          ╲     NO
         ⟨  ALL WAVELENGTH          ⟩─────────────┐
          ╲   BANDS BEEN          ╱               │
            ╲   APPLIED?        ╱                 │
              ╲─────────────────╱                 │
                       │ YES                      │
                       ▼                          ▼
        ┌──────────────────────────────┐   ┌──────────────────────────────┐
        │  CONVERT NUMBER OF           │   │  IRRADIATION WITH PULSE       │
        │  INTEGRATED EVENT            │   │  OF LIGHT IN ANOTHER          │
        │  SIGNALS IN ALL              │   │  WAVELENGTH BAND              │
        │  WAVELENGTH BANDS INTO       │   └──────────────────────────────┘
        │  LUMINANCE VALUES            │  ⌐S105        ⌐S104
        └──────────────┬─────────────────┘
                       │
                       ▼
        ┌──────────────────────────────┐
        │     GENERATE IMAGE           │  ⌐S106
        └──────────────┬─────────────────┘
                       │
                       ▼
                ┌─────────────┐
                │     END     │
                └─────────────┘
```

# FIG.21

START

APPLY LIGHT IN SPECIFIC WAVELENGTH BAND WITH HIGH LUMINOUS INTENSITY — S201

ACQUIRE LUMINANCE — S202

APPLY LIGHT IN WAVELENGTH BAND BEING IN USE, WITH LOW LUMINOUS INTENSITY — S203

ACQUIRE LUMINANCE — S204

ACQUIRE DIFFERENCE IN LUMINANCE BETWEEN HIGH LUMINANCE AND LOW LUMINANCE — S205

HAS LIGHT IN ALL WAVELENGTH BANDS BEEN APPLIED? — S206

NO → APPLY LIGHT IN ANOTHER WAVELENGTH BAND WITH HIGH LUMINOUS INTENSITY — S207

YES

CONVERT DIFFERENCE IN LUMINANCE OF LIGHT IN ALL WAVELENGTH BANDS INTO LUMINANCE VALUES — S208

GENERATE IMAGE — S209

END

## INTERNATIONAL SEARCH REPORT

| International application No. |
|---|
| **PCT/JP2023/040048** |

| A. | CLASSIFICATION OF SUBJECT MATTER |
|---|---|

*H04N 23/60*(2023.01)i; *H04N 23/56*(2023.01)i; *H04N 25/20*(2023.01)i; *H04N 25/47*(2023.01)i
FI:   H04N23/60 500; H04N23/56; H04N25/20; H04N25/47

According to International Patent Classification (IPC) or to both national classification and IPC

| B. | FIELDS SEARCHED |
|---|---|

Minimum documentation searched (classification system followed by classification symbols)

     H04N23/60; H04N23/56; H04N25/20; H04N25/47

Documentation searched other than minimum documentation to the extent that such documents are included in the fields searched

     Published examined utility model applications of Japan 1922-1996
     Published unexamined utility model applications of Japan 1971-2023
     Registered utility model specifications of Japan 1996-2023
     Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | WO 2016/006499 A1 (OLYMPUS CORP ) 14 January 2016 (2016-01-14) paragraphs [0001], [0023], [0032], [0049]-[0050], fig. 3 | 1-2, 6-7, 10-12 |
| Y | | 3, 5 |
| A | | 4, 8-9 |
| Y | JP 2016-39393 A (SONY CORP) 22 March 2016 (2016-03-22) paragraph [0217], fig. 15B | 3 |
| Y | WO 2022/215371 A1 (SONY SEMICONDUCTOR SOLUTIONS CORP) 13 October 2022 (2022-10-13) paragraph [0023] | 3 |
| Y | WO 2021/019973 A1 (PANASONIC IP MAN CO LTD) 04 February 2021 (2021-02-04) paragraph [0034] | 5 |
| A | JP 2021-129265 A (SONY SEMICONDUCTOR SOLUTIONS CORP) 02 September 2021 (2021-09-02) paragraphs [0037]-[0055] | 4, 8-9 |

☐ Further documents are listed in the continuation of Box C.    ☑ See patent family annex.

| | |
|---|---|
| *   Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| **08 December 2023** | **09 January 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/040048**

| Patent document cited in search report | | | Publication date (day/month/year) | Patent family member(s) | Publication date (day/month/year) |
|---|---|---|---|---|---|
| WO | 2016/006499 | A1 | 14 January 2016 | US 2016/0360948 A1 paragraphs [0003], [0024], [0033], [0050]-[0051], fig. 3 | |
| JP | 2016-39393 | A | 22 March 2016 | US 2017/0214864 A1 paragraph [0369], fig. 15B | |
| WO | 2022/215371 | A1 | 13 October 2022 | (Family: none) | |
| WO | 2021/019973 | A1 | 04 February 2021 | US 2022/0094873 A1 paragraph [0058] | |
| JP | 2021-129265 | A | 02 September 2021 | US 2023/0071929 A1 paragraphs [0111]-[0153] | |

Form PCT/ISA/210 (patent family annex) (January 2015)

**EP 4 629 649 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017535999 A